# EUROPEAN PATENT SPECIFICATION

(11) **EP 0 892 333 B1**
(45) Date of publication and mention of the grant of the patent: **21.12.2005**
(21) Application number: 98113058.6
(22) Date of filing: 14.07.1998
(51) Int. Cl.: G05F 3/22, G05F 3/26

(54) **Current source circuit**
Stromquellenschaltung
Circuit source de courant

(30) Priority: 14.07.1997 JP 18872597; 10.06.1998 JP 16215398
(43) Date of publication of application: 20.01.1999
(73) Proprietor: KABUSHIKI KAISHA TOSHIBA, Kawasaki-shi, Kanagawa-ken 210-8572 (JP)
(72) Inventor: Okada, Hiroshi, 1-1 Shibaura 1-chome Minato-ku Tokyo 105 (JP); Itoh, Naoki, 1-1 Shibaura 1-chome Minato-ku Tokyo 105 (JP)
(74) Representative: Zangs, Rainer E.

(56) References cited:
- EP-A- 0 299 723
- WO-A-82/01105
- US-A- 4 525 683

## Description

The present invention relates to a semiconductor integrated circuit using bipolar transistors and, more particularly, a current source circuit which is improved in respect of the variation in the input/output current ratio due to the dispersions of elements and the change in ambient temperature.

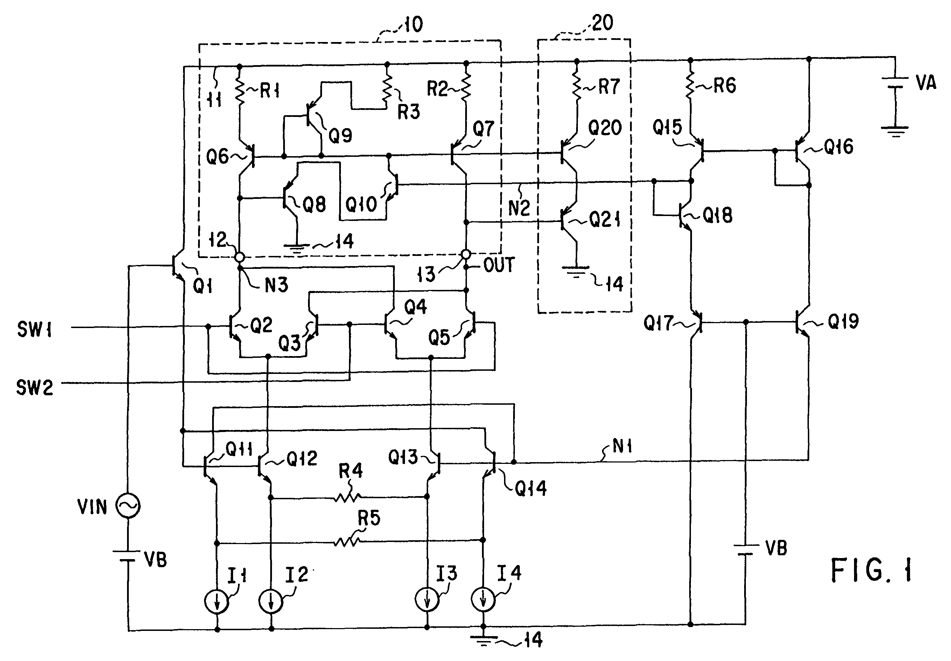

FIG. 1 shows the constitutional arrangement of a conventional synchronous detection circuit as an example of a semiconductor integrated circuit provided with a current source circuit.

In this synchronous detection circuit, an input signal VIN superimposed on a DC bias voltage VB is supplied to the base of an NPN transistor Q1. Further, two pairs of NPN transistors Q2, Q3 and Q4, Q5 arranged in such a manner that the emitters of the transistors in the respective pairs are connected to each other are controlled in synchronism with switch control signals SW1, SW2 supplied to the bases of the respective transistors, whereby, from the common collectors of the transistors Q3, Q5, a detection output signal OUT is derived.

In this case, used as a load to the transistors Q2, Q3, Q4 and Q5 is a current mirror circuit (current source circuit) 10 comprised of PNP transistors Q6, Q7, Q8 and Q9, an NPN transistor Q10, and resistors R1, R2 and R3.

In this current mirror circuit 10, the emitter of the transistor Q6 is connected to a voltage node 11 through the resistor R1. A positive DC bias voltage VA is supplied to the node 11. The collector of the transistor Q6 is connected to a current input terminal 12. Also connected to this current input terminal 12 are the respective collectors of the transistor Q2, Q4. The emitter of the transistor Q7 is connected to the voltage node 11 through the resistor R2. The base of the transistor Q7 is connected commonly to the base of the transistor Q6, and the collector thereof is connected to a current output terminal 13. Also connected to this current output terminal 13 are the respective collectors of the transistors Q3, Q5. The emitter of the transistor Q9 is connected to the voltage node 11 through the resistor R3. The base and collector of the transistor Q9 are connected to the common bases of the transistors Q6 and Q7. The transistor Q9 and the resistor R3 are provided for preventing the current mirror circuit 10 from oscillating.

The collector of the transistor Q10 is connected to the common base of the transistors Q6 and Q7. The emitter of the transistor Q10 is connected to the emitter of the transistor Q8. The base of the transistor Q8 is connected to the collector of the transistor Q6, while the collector of the transistor Q8 is connected to a voltage node 14 which is supplied with the earth voltage.

Further, the circuit consisting of NPN transistors Q11, Q12, Q13 and Q14, resistors R4 and R5, and constant-current sources I1, I2, I3 and I4 feeds the common emitter of the transistors Q2, Q3 and the common emitter of the transistors Q4, Q5 with a current corresponding to the input signal VIN or a current corresponding to the constant voltage generated by a constant-voltage generation circuit to be described later, the circuit being constituted as follows:

That is, the bases of the transistors Q11, Q12 are connected to the emitter of the transistor Q1. The collector of the transistor Q11 is connected to a node N1 which is supplied with the constant voltage, while the emitter thereof is connected through the constant-current source I1 to the voltage node 14 placed at the earth voltage. The collector of the transistor Q12 is connected to the common emitter of the transistors Q2, Q3, while the emitter thereof is connected to the voltage node 14 through the constant-current source I2. The bases of the transistors Q13, Q14 are connected to the node N1. The collector of the transistor Q13 is connected to the common emitter of the transistors Q4, Q5, while the emitter thereof is connected to the voltage node 14 through the constant-current source I3. The collector of the transistor Q14 is connected to the emitter of the transistor Q1, while the emitter thereof is connected to the voltage node 14 through the constant-current source I4.

Further, between the emitters of the transistors Q12, Q13, the resistor R4 is connected, while between the emitters of the transistors Q11, Q14, the resistor R5 is connected.

The circuit consisting of PNP transistors Q15, Q16, Q17, NPN transistors Q18, Q19, and a resistor R6 constitutes a constant-voltage generation circuit. That is, the emitter of the transistor Q15 is connected to the voltage node 11 through the resistor R6. The emitter of the transistor Q16 is connected to the voltage node 11, while the base thereof is connected to the base of the transistor Q15. Further, the base and collector of the transistor Q16 are short-circuited to each other. The collector and base of the transistor Q18 are connected to the collector of the transistor Q15. Further, a common connection node N2 between the collector and base of the transistor Q18 is connected to the base of the transistor Q10. The emitter of the transistor Q17 is connected to the emitter of the transistor Q18.

The collector of the transistor Q19 is connected to the collector of the transistor Q16. Further, the bases of the transistors Q17, Q19 are commonly connected to each other, and, to these commonly connected bases, a DC bias voltage VB is supplied. The collector of the transistor Q17 is connected to the voltage node 14, and the emitter of the transistor Q19 is connected to the node N1.

By the way, in a current mirror circuit in general, there is provided means for correcting the error in the input/output current ratio which is caused by the base currents of transistors etc.; and, in the case of the current mirror circuit 10 shown in FIG. 1, the transistors Q8 and Q10 are provided for correcting the error in the input/output current ratio due to the base current of the transistors Q6, Q7 and the base-collector current of the transistor Q9, and further, a current of a value corresponding to the currents which cause the error is made to flow to the earth voltage node through the transistor Q8.

However, the base current itself of the correcting transistor Q8 joins to the collector current of the transistor Q6; and thus, the base current causes an error in the input/output current ratio of the current mirror circuit.

Due to this, in the circuit shown in FIG. 1, a correction circuit 20 is further provided to correct the error due to the base current of the transistor Q8.

This correction circuit 20 is comprised of PNP transistors Q20, Q21, and a resistor R7. That is, the emitter of the transistor Q20 is connected to the voltage node 11 through the resistor R7, while the base thereof is connected to the common base of the transistors Q6, Q7 in the current mirror circuit 10. The emitter of the transistor Q21 is connected to the collector of the transistor Q20, the base thereof is connected to the collector of the transistor Q7 in the current mirror circuit 10, and the collector thereof is connected to the voltage node 14.

In the correction circuit 20, the transistor Q20 constitutes a current mirror together with the transistor Q6 in the current mirror circuit 10. Further, by setting the value of the resistor R7 so that the base currents of the transistors Q8 and Q21 may become equal to each other, the sum of the collector current of the transistor Q6 and the base current of the transistor Q8 and the sum of the collector current of the transistor Q7 and the base current of the transistor Q21 are equalized to each other. By so doing, the error in the input/output current ratio caused by the base current of the transistor Q8 is corrected.

By the way, in the conventional circuit shown in FIG. 1, the value of the base current of the transistor Q8 becomes l/hfe (wherein hfe stands for the current amplification factor) times as large as the total sum of the base current of the transistor Q6, the base current of the transistor Q7, the base current and collector current of the transistor Q9, and the base current of the transistor Q20. The correction for the base current of the transistor Q8 is made by only the base current (which is l/hfe times as large as the collector current of the transistor Q20) of the transistor Q21.

Due to this, even if the value of the base current of the transistor Q21 is set or adjusted under a certain condition, an unbalance is caused between the base currents of the transistors Q8 and Q21 in some cases due to the dispersions of the elements and the variation in ambient temperature. As a result, there arises the problem that the values of the currents which flow to the node 13 at which the detection output signal OUT is derived and to the node N3 which is paired with the node 13 and is the common collector node of the transistors Q2, Q4 are varied due to the dispersions of the elements and the variation in the ambient temperature, as a result of which the input/output current ratio comes to vary.

Further, so far, the potential at the node N3 paired with the node at which the detection output signal OUT is derived is determined by the VB + VBE (Q17) + VBE (Q18) - VBE (Q10) - VBE (Q8) , wherein VBE (Qi) (i = 1, 2 ...) stands for the base-emitter voltages of the respective transistors. However, the potential at the node at which the detection output signal OUT is obtained is not determined unconditionally, becoming indeterminate. Due to this, there has also been caused the problem that the values of the emitter-collector voltages VCE of the transistors Q6 and Q7 become different from each other; and, by the influence of the early effect, the collector currents of the transistors Q6 and Q7 become unbalanced.

Thus, it is the object of the present invention to provide a current source circuit constituted in such a manner that the input/output current ratio of the current mirror circuit can always be maintained constant without being affected by the dispersions of the elements and the variation in the ambient temperature.

Another object of the present invention is to provide a current source circuit constituted in such a manner that the occurrence of an unbalance between the collector currents by the influence of the early effect based on the difference between the emitter-collector voltages of a pair of transistors constituting a current mirror circuit can be prevented.

According to an embodiment of the present invention, there is provided a current source circuit comprising: a first voltage node to which a first voltage is supplied; a second voltage node to which a second voltage lower than the first voltage is supplied; a current mirror circuit including a first transistor of a first polarity, which has a base, an emitter and a collector, the emitter of the first transistor is coupled to the first voltage node, a second transistor of the first polarity, which has a base, an emitter and a collector, the emitter of the second transistor is coupled to the first voltage node, the base of the second transistor is connected commonly to the base of the first transistor, and a third transistor of the first polarity, which has a base, an emitter and a collector, the emitter of the third transistor is coupled to a base common connection node of the first and second transistors, the base of the third transistor is connected to the collector of the first transistor, the collector of the third transistor is connected to the second voltage node, and a ninth transistor of the first polarity which has a base, an emitter and a collector, the emitter of the ninth transistor is coupled to the first voltage node, the base and collector of the ninth transistor is connected to the base common connection node of the first and second transistors, wherein the collectors of the first and second transistors are used as current input and output terminals of the current mirror circuit. Inventively in this current source circuit a correction circuit is provided including a fourth transistor of the first polarity, which has a base, an emitter and a collector, the emitter of the fourth transistor is coupled to the first voltage node, a fifth transistor of the first polarity, which has a base, an emitter and a collector, the emitter of the fifth transistor is coupled to the first voltage node, the base of the fifth transistor is connected commonly to the base of the fourth transistor, the collector of the fifth transistor is connected to the second voltage node, a sixth transistor of the first polarity, which has a base, an emitter and a collector, the emitter of the sixth transistor is coupled to the first voltage node, the base of the sixth transistor is connected commonly to the bases of the fourth and fifth transistors, a seventh transistor of the first polarity, which has a base, an emitter and collector, the emitter of the seventh transistor is connected to a base common connection node of the fourth, fifth and sixth transistors, the base of the seventh transistor is connected to the collector of the fourth transistor, the collector of the seventh transistor is connected to the collector of the sixth transistor, and an eighth transistor of the first polarity, which has a base, an emitter and a collector, the emitter of the eighth transistor is connected to the collector of the seventh transistor, the base of the eighth transistor is connected to the collector of the second transistor, the collector of the eighth transistor is connected to the second voltage node.

According to one particular design of this embodiment of the invention, the emitter of the third transistor is directly connected to the base common connection node of the first and second transistors.

According to another particular design of this embodiment of the invention, in order to couple in the current mirror circuit the emitter of the third transistor to the base common connection node of the first and second transistors , the current mirror circuit further includes a further transistor of a second polarity opposite to said first polarity, which has a base, an emitter and a collector, the collector of the further transistor is connected to the base common connection node of the first and second transistors, the emitter of the further transistor is connected to the emitter of the third transistor; and the correction circuit further includes a ninth transistor of the second polarity, which has a base, an emitter and a collector, the base and the collector of the ninth transistor is connected to the base of the further transistor, and the emitter of the ninth transistor is connected to the emitter of the eighth transistor.

Particular features of advantageous embodiments of the invention define the subject matter of attached sub-claims.

This summary of the invention does not necessarily describe all necessary features so that the invention may also be a sub-combination of these described features. ,

This invention can be more fully understood from the following detailed description when taken in conjunction with the accompanying drawings, in which:
FIG. 1 is a circuit diagram of a conventional synchronous detection circuit;
FIG. 2 is a circuit diagram of the synchronous detection circuit according to a first embodiment of the present invention;
FIG. 3 is a circuit diagram of the synchronous detection circuit according to a second embodiment of the present invention;
FIG. 4 is a circuit diagram of the synchronous detection circuit according to a third embodiment of the present invention;
FIG. 5 is a circuit diagram of the synchronous detection circuit according to a fourth embodiment of the present invention; and
FIG. 6 is a circuit diagram of the synchronous detection circuit according to a fifth embodiment of the present invention.

Embodiments of the present invention will now be described by reference to the drawings.

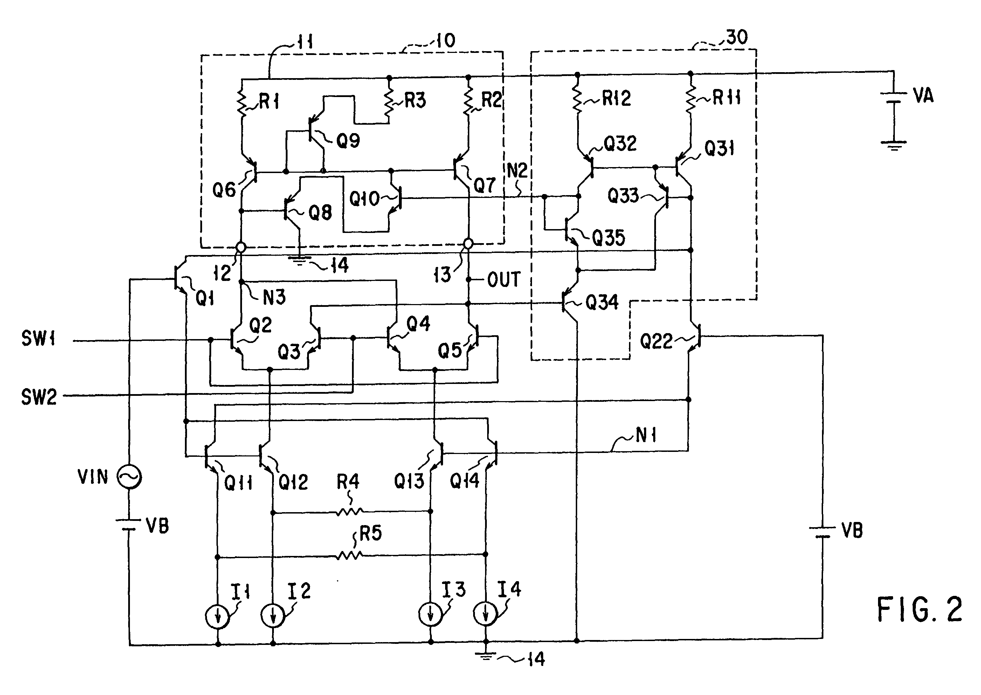

FIG. 2 is a circuit diagram of the semiconductor integrated circuit according to a first embodiment of the present invention; as the semiconductor integrated circuit, a synchronous detection circuit is exemplarily shown as in the case of the conventional semiconductor integrated circuit. In the description to follow, the constitutent portions which correspond to those in the conventional circuit shown in FIG. 1 are referenced by the same reference numerals.

Supplied to the base of an NPN transistor Q1 is an input signal VIN superimposed on a DC bias voltage VB. In the case of the conventional circuit shown in FIG. 1, the collector of this transistor Q1 is connected to the voltage node 11 to which the DC bias voltage VA is supplied, but in this embodiment, the collector of the transistor Q1 is connected to a predetermined node in a collection circuit to be described later.

The emitters of each of two pairs of NPN transistors Q2, Q3 and Q4, Q5 are connected commonly to each other, and, to the bases of the transistors Q2 and Q5, a switch control signal SW1 is supplied, while to the bases of the transistors Q3, Q4, a switch control signal SW2 is supplied. The collectors of the transistors Q2, Q4 are commonly connected to each other, and the collectors of the transistors Q3, Q5 are connected commonly to each other. Further, from a common connection node of the collectors of the transistors Q3, Q5, a detection output signal OUT is derived.

Used as a load to the transistors Q2, Q3, Q4 and Q5 is a current mirror circuit 10 which is comprised of PNP transistors Q6, Q7, Q8 and Q9, an NPN transistor Q10 and resistors R1, R2 and R3.

In the current mirror circuit 10, the emitter of the transistor Q6 is connected through the resistor R1 to the voltage node 11 to which a positive DC bias voltage VA is supplied. The collector of the transistor Q6 is connected to a current input terminal 12. Connected to this current input terminal 12 is the common collector of the transistors Q2, Q4. The emitter of the transistor Q7 is connected to the voltage node 11 through the resistor R2. The base of the transistor Q7 is connected commonly to the base of the transistor Q6, while the collector thereof is connected to a current output terminal 13. Connected to this current output terminal 13 is the common collector of the transistors Q3, Q5. The emitter of the transistor Q9 is connected to the voltage node 11 through the resistor R3. The base and collector of the transistor Q9 are connected to the common base of the transistors Q6, Q7.

The transistor Q9 and the resistor R3 are provided for preventing the current mirror circuit from oscillating.

In the case of the synchronous detection circuit according to this embodiment, a new correction circuit 30 is provided in place of the conventional correction circuit 20. This correction circuit 30 comprises PNP transistors Q31, Q32, Q33 and Q34, an NPN transistor Q35, and resistors R11, R12.

This correction circuit 30 corrects the base current of the transistor Q8 in the current mirror 10 and, at the same time, corrects the unbalanced state of the collector currents, based on the early effect, of the transistors Q6 and Q7

The PNP transistors Q31 and Q32 correspond to the transistors Q6 and Q7 in the current mirror circuit 10; and the bases of the transistors Q31 and Q32 are connected commonly to each other as in the case of the transistors Q6, Q7. Further, the resistors R11 and R12 correspond to the resistors R1, R2 in the current mirror circuit 10, and, through the resistors R11, R12, the transistor Q31, Q32 are connected to the voltage node 11 to which the DC bias voltage VA is supplied.

The emitter of the transistor Q33 is connected to the common base of the transistors Q31, Q32, while the base thereof is connected to the collector of the transistor Q31. Further, the emitter of the transistor Q34 is connected to the collector of the transistor Q33, while the base thereof is connected the collector of the transistor Q7 in the current mirror circuit 10, while the collector thereof is connected to the voltage node 14 placed at the earth voltage.

The collector and base of the transistor Q35 are connected to the collector of the transistor Q32 and also to a node N2 to which the base of the transistor Q10 in the current mirror circuit 10. The emitter of the transistor Q35 is connected to the emitter of the transistor Q34. The collector of the transistor Q34 is connected to the node 14.

Further, in the circuit according to this embodiment, in order to apply a constant voltage to the above-mentioned node N1, there is provided an NPN type transistor Q22. That is, the collector of the transistor Q22 is connected to the collector of the above-mentioned transistor Q1 and also to the collector of the transistor Q31, the emitter thereof is connected to the node N1, and the base thereof is supplied with a DC bias voltage VB.

The current ratio of the constant-current sources I1, I2, I3 and I4 are set to 1 : 2 : 2 : 1.

In this synchronous detection circuit, the transistors Q31 to Q35 and the resistors R11 and R12 are provided in the correction circuit 30 to thereby constitute within the correction circuit 30 a current mirror equal to the current mirror comprising the transistors Q6, Q7, Q10, Q8 and the resistors R1, R2 in the current mirror circuit 10, and further, the transistor Q35 is provided in such a manner that the base-emitter current path thereof is inserted between the emitter of the transistor Q34 and the base of the transistor Q10 in the current mirror circuit 10.

Further, in order to generate a constant voltage to be supplied to the node N1, the transistor Q22 corresponding to the transistor Q1 is added.

Further, in the current mirror circuit 10, the resistors R1 to R3 can be omitted, but in case they are omitted, the resistors R11 and R12 in the correction circuit 30 can be omitted.

As for the circuit shown in FIG. 2, in the current mirror circuit 10, the base current of the transistor Q8 flows into the collector of the transistor Q6 from the common base of the transistors Q6, Q7 through the collector-emitter current path of the transistor Q10 and through the emitter-base current path of the transistor Q8.

On the other hand, in the correction circuit 30, the base current of the transistor Q34 flows into the collector of the transistor Q7 from the common base of the transistors Q31, Q32 through the emitter-collector current path of the transistor Q33 and through the emitter-base current path of the transistor Q34.

Due to this, various conditions such as the element sizes of the transistors Q6 and Q31, the transistors Q7 and Q32, the transistors Q10 and Q35, and the transistors Q8 and the Q34, and the resistance values of the resistors R1 and R11, and the resistors R2 and R12 are made equal to each other, whereby the base current of the transistor Q8 can be set to approximately the same value of the base current of the transistor Q34.

Here, it is to be noted that, in case dispersions are caused among the elements when manufactured, the dispersions of the elements which are equal in respect of the various conditions become equal to one another, so that the values of the two base currents vary equally in accordance with the dispersions of the elements. Further, in case the ambient temperature is taken into consideration, it is pointed out that, since the circuit arrangement of the portion of the correction circuit 30 in which the base current of the transistor Q34 is produced is approximately equal to that in the current mirror circuit 10, the variations of the two base currents due to the variation in ambient temperature becomes equal to each other. As a result, the input/output current ratio of the current mirror circuit can be maintained constant without being influenced by the dispersions of the elements and the variation in emboldened temperature.

On the other hand, the voltage at a node N3 (the current input terminal 12 of the current mirror circuit 10) which is a common collector node of the transistors Q2, Q4 assumes the value determined in such a manner that the voltage at the node (the current output terminal 13 of the current mirror circuit 10) at which the detection output signal OUT is derived is raised by a value corresponding to the respective base-emitter voltages VBE of the transistors Q34, Q35, and the resulting voltage value is lowered by a value corresponding to the respective base-emitter voltages VBE of the transistors Q10, Q8. Here, generally it can safely be considered that the respective VBE of a PNP transistor and that of an NPN transistor are equal to each other, so that the voltage at the node N3 turns out to be equal to the voltage at the node at which the detection output signal OUT is derived. As a result, the emitter-collector voltages VCE of the transistors Q6 and Q7 can be equalized to each other; and thus, the problem that, by the influence of the early effect caused by the fact that the values of the respective emitter-collector voltages VCE differ from each other, the collector currents of the transistor Q6 and Q7 become unbalanced can be overcome.

Further, the voltage at the node N1 becomes a constant voltage having the value lower by the base-emitter voltage of the transistor Q22 than the DC bias voltage VB.

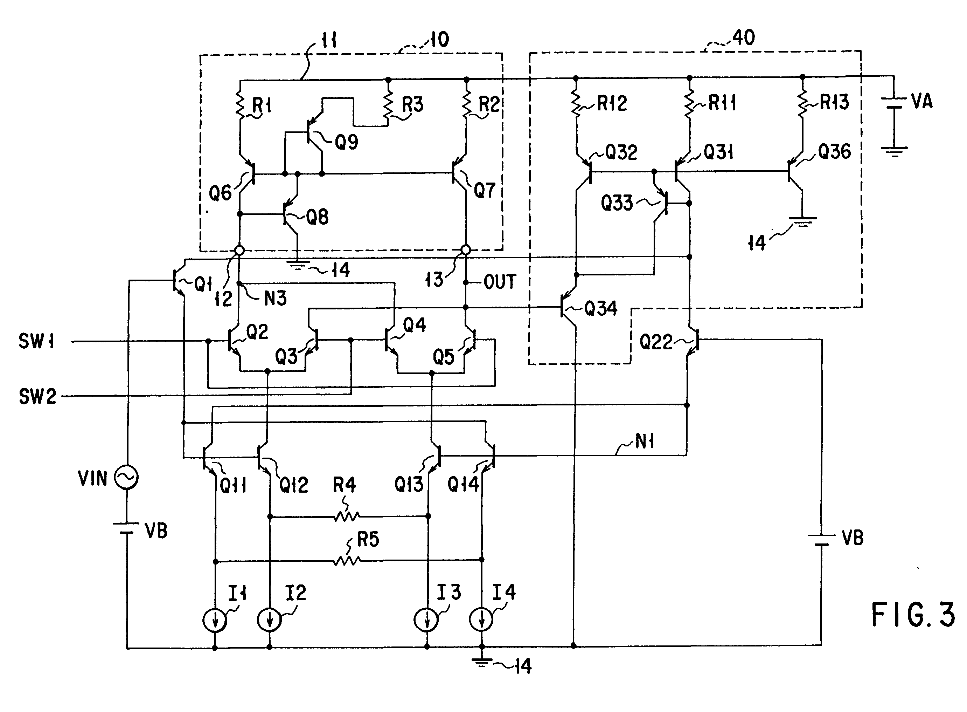

FIG. 3 shows the constitutional arrangement of the semiconductor integrated circuit according to a second embodiment of the present invention. In this circuit shown in FIG. 3, the constitutent portions which correspond to those of the circuit according to the first embodiment shown in FIG. 2 are referenced by the same reference symbols.

The synchronous detection circuit according to this second embodiment differs from the synchronous detection circuit shown in FIG. 2 in that the transistor Q10 in the current mirror 10 is omitted, that the emitter of the base current correction transistor Q8 is directly connected to the common base of the transistors Q6 and Q7, and that, in place of the correction circuit 30 shown in FIG. 2, a different correction circuit 40 is provided.

The correction circuit 40 differs form the correction circuit 30 shown in FIG. 2 in that the transistor Q35 is omitted in association with the fact that the transistor Q10 in the current mirror circuit 10 is omitted, and that a PNP transistor Q36 and a resistor R13 are newly added. Due to the omission of the transistor Q35, the collector of the transistor Q32 is connected to the emitter of the transistor Q34.

Further, the emitter of the newly added transistor Q36 is connected through the resistor R13 to the voltage node 11 to which the DC bias voltage VA is supplied. Further, the base of this transistor Q36 is connected to the base common connection node of the transistors Q31, Q32, and the collector thereof is connected to the voltage node 14 to which the earth voltage is supplied.

Further, in the case of this second embodiment, the resistors R1 to R3 may be omitted in the current mirror circuit 10, but, in case the resistors are omitted, the resistors R11 to R13 can be likewise omitted on the side of the correction circuit 40.

With such a constitutional arrangement, in the current mirror circuit 10, the base current of the transistor Q8 flows into the collector of the transistor Q6 from the common base of the transistors Q6 and Q7 through the emitter-base current path of the transistor Q8.

On the other hand, in the correction circuit 40, the base current of the transistor Q34 flows into the collector of the transistor Q7 from the common base of the transistors Q31, Q32 and Q36 through the emitter-base current path of the transistor Q33 and the emitter-base current path of the transistor Q34.

Here, it is to be noted that the base current of the transistor Q8 in the current mirror circuit 10 turns out to be l/hfe of the total sum of the base current of the transistor Q6, the base current and the collector current of the transistor Q9, and the base current of the transistor Q7, that is, l/hfe of the total sum of the base currents of three transistors and the collector current of one transistor; and thus, the base current of the transistor Q8 can be represented as (Ic + 3Ib)/hfe wherein Ib stands for a base current, and Ic stands for a collector current.

On the other hand, in the correction circuit 40, the collector current of the transistor Q33 becomes 3Ib - α which is slightly smaller than the total sum of the base currents of the three transistors Q31, Q32 and Q36. To the collector of the transistor Q34, the collector current of the transistor Q33 and the collector current of the transistor Q32 join together, so that, if it is assumed that Ic stands for the collector current of the transistor Q32, then the collector current of the transistor Q34 is represented as (Ic + 3Ib - α), and the base current of the transistor Q34 is represented as (Ic + 3Ib - α)/hfe . Here, the α/hfe is sufficiently small as compared with (Ic + 3Ib)/hfe , so that the base current of the transistor Q8 and the base current of the transistor Q34 can safely be regarded as approximately equal to each other.

Here, it is to be noted that, in case dispersions are caused among the elements when manufactured, the dispersions of the elements which are equal in respect of the various conditions become equal, so that the values of the two base currents vary equally in accordance with the dispersions of the elements. Further, in case the ambient temperature is taken into consideration, it is pointed out that the circuit arrangement of the portion of the correction circuit 40 in which the base current of the transistor Q34 is generated is approximately equal to that of the current mirror circuit 10, so that the variations of the two base currents due to the variation in ambient temperature also become equal.

As a result, in the case of the embodiment shown in FIG. 3, it is also possible to maintain the input/output current ratio of the current mirror circuit constant without being affected by the dispersions of the elements and the variation in the ambient temperature.

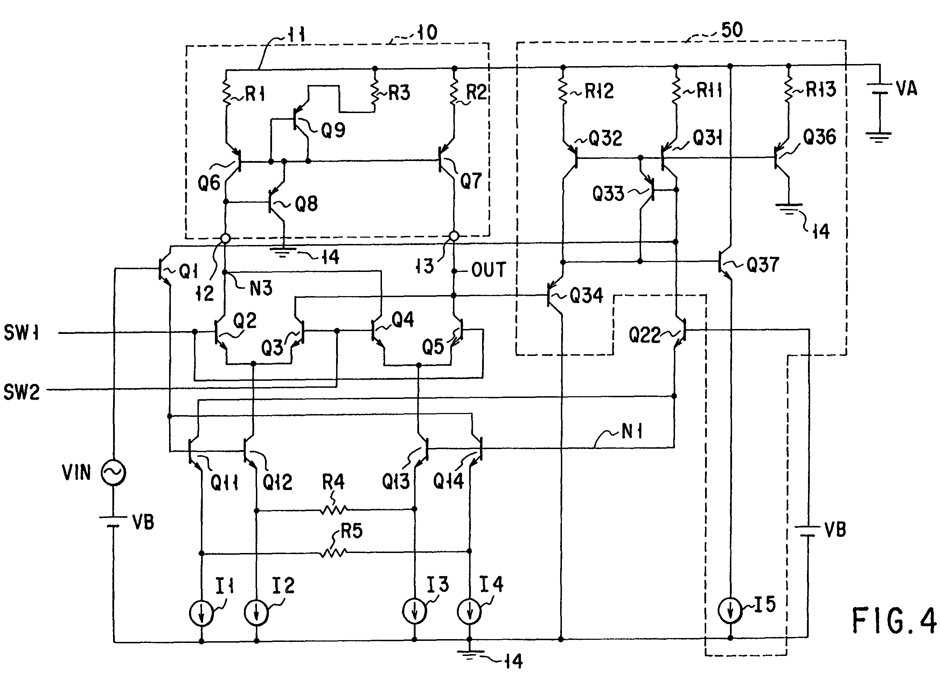

Next, a third embodiment of the present invention will be described, referring to FIG. 4.

The synchronous detection circuit according to this embodiment differs from the synchronous detection circuit shown in FIG. 3 in that, in place of the correction circuit 40 shown in FIG. 3, a different correction circuit 50 is provided. The correction circuit 50 differs from the correction circuit 40 shown in FIG. 3 in that an NPN transistor Q37 and a constant-current source 15 are newly added.

The collector of the newly added transistor Q37 is connected to the voltage node 11 to which the DC bias voltage VA is supplied, and the base thereof is connected to the collector of the transistor Q32. Further, the emitter of the transistor Q37 is connected through the constant-current source 15 to the voltage node 14 to which the earth voltage is applied.

As shown, to the collector of the transistor Q31 in the correction circuit 50, the base currents of the transistors Q11 to Q14 and the collector currents of the transistors Q11 and Q14 flow through the transistor Q1 or Q22. That is, the collector current of the transistor Q31 is increased by an amount corresponding to the currents flowing through these transistors Q11 to Q14. In response to this, the collector current of the transistor Q32 is also increased, as a result of which a discrepancy is caused between the base current of the transistor Q8 in the current mirror circuit 10 and the base current of the transistor Q34 in the correction circuit in some cases.

In the correction circuit 50 according to this embodiment, the increased amount of the collector current of the transistor Q32 due to the currents flowing through the transistors Q11 to Q14 can be made to flow as the base current to the transistor Q37, so that the discrepancy between the base current of the transistor Q8 in the current mirror circuit 10 and the base current of the transistor Q34 in the correction circuit 50 can be sufficiently reduced, whereby the input/output current ratio in the current mirror circuit 10 can be maintained constant.

The constant-current source 15 should be formed by the use of transistors having uniform characteristics as well as the above-mentioned constant-current sources I1 to I4.

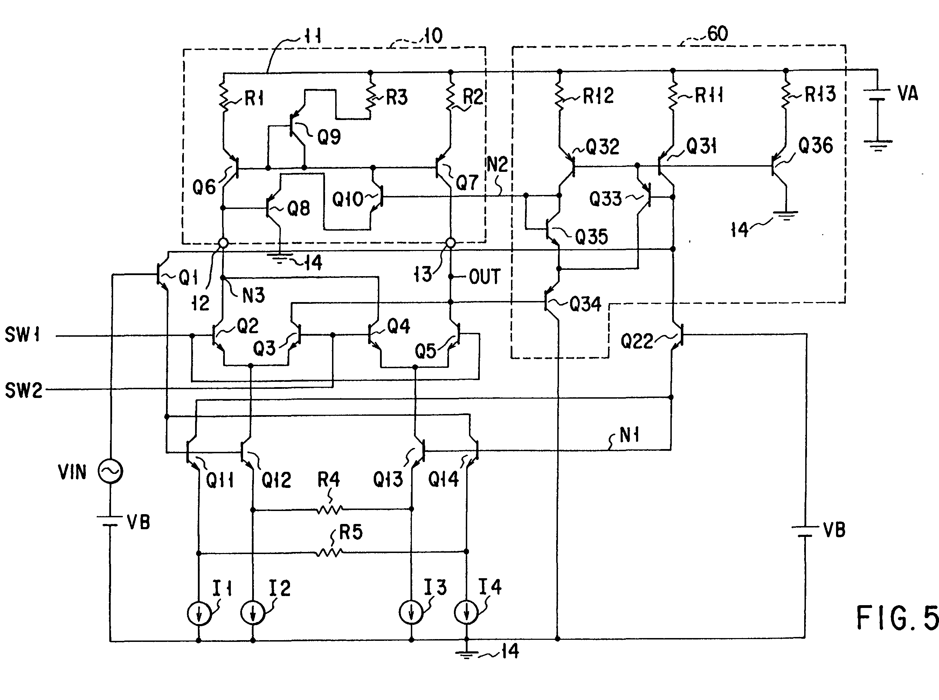

Next, a fourth embodiment of the present invention will be described by reference to FIG. 5.

In the synchronous detection circuit according to this embodiment, in place of the correction circuit 30 according to the first embodiment shown in FIG,. 2, a different correction circuit 60 is provided.

The correction circuit 60 differs from the correction circuit 30 shown in FIG. 2 in that the correction circuit 60 is constituted in such a manner that the transistor Q36 and the resistor R13 in the correction circuit 40 shown in FIG. 3 are added into the correction circuit 30 shown in FIG. 2.

Therefore, according to this fourth embodiment, the correction of the base current component of the transistor Q8 can be made, by the correction circuit 60, in association with the collector current and the base current of the oscillation preventing transistor Q9 in the current mirror circuit 10 as in the case of the embodiment shown in FIG. 3; and thus, the current correction can be effected at a higher accuracy.

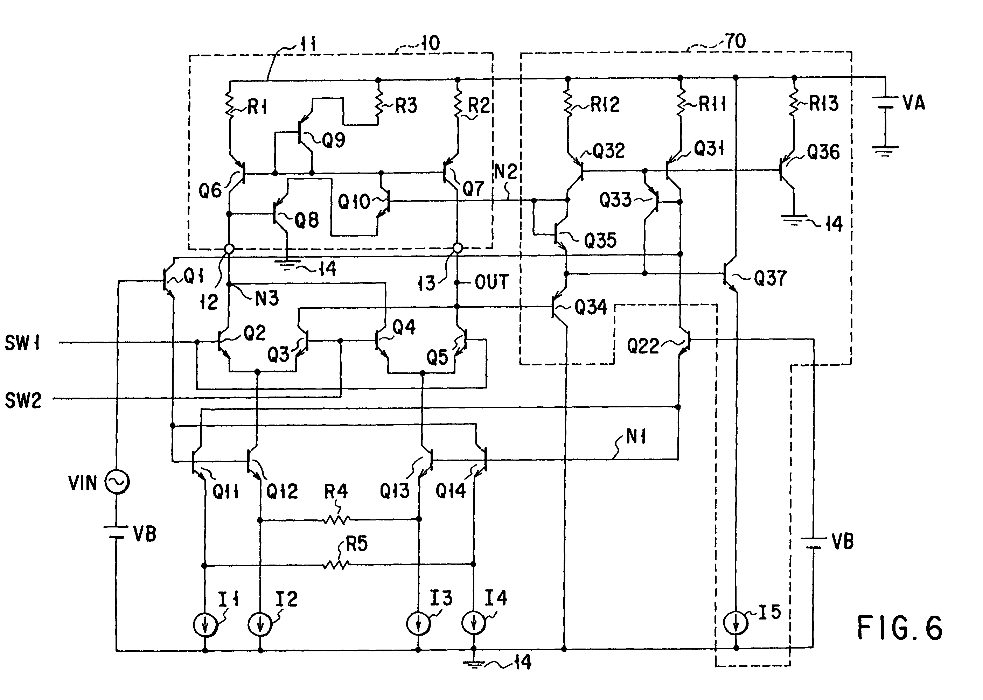

Next, a fifth embodiment of the present invention will be described by reference to FIG. 6.

In the synchronous detection circuit according to this embodiment, in place of the correction circuit 60 according to the fourth embodiment shown in FIG. 5, a different correction circuit 70 is provided.

The correction circuit 70 differs from the correction circuit 60 shown in FIG. 5 in that, into the correction circuit 60 shown in FIG. 5, the transistor Q37 and constant-current source I5 in the correction circuit 50 shown in FIG. 4 are added.

Therefore, according to this embodiment, there can be obtained the effect that, on the basis of the currents flowing through the transistors Q11 to Q14, the discrepancy caused between the base current of the transistor Q8 in the current mirror circuit 10 and the base current of the transistor Q34 in the correction circuit 70 can be sufficiently reduced, whereby the input/output current ratio in the current mirror circuit 10 can be made constant.

It is a matter of course that the present invention is not limited only to the above-described embodiments but can be variously modified. For instance, in the respective embodiments mentioned above, the present invention is applied to synchronous detection circuits, but the current source circuit according to the present invention can be easily applied in circuits directed to any other use.

As described above, according to the present invention, there can be provided a current source circuit constituted in such a manner that the input/output current ratio of a current mirror circuit can be maintained constant without being affected by the dispersions of the elements and the variation in ambient temperature.

Further, according to the present invention, the occurrence of an unbalanced state of the collector currents by the influence of the early effect based on the difference between the emitter-collector voltages of the transistors constituting the current mirror circuit can also be prevented.

## Claims

1. Current source circuit comprising:
a first voltage node (11) to which a first voltage (VA) is supplied;
a second voltage node (14) to which a second voltage lower than the first voltage is supplied;
a current mirror circuit (10) including a first transistor (Q6) of a first polarity having a base, an emitter and a collector, the emitter of the first transistor (Q6) being coupled to the first voltage node, a second transistor (Q7) of the first polarity having a base, an emitter and a collector, the emitter of the second transistor (Q7) being coupled to the first voltage node, the base of the second transistor (Q7) being connected commonly to the base of the first transistor (Q6), and a third transistor (Q8) of the first polarity having a base, an emitter and a collector, the emitter of the third transistor (Q8) being coupled to a base common connection node of the first and second transistors (Q6, Q7), the base of the third transistor (Q8) being connected to the collector of the first transistor (Q6), the collector of the third transistor (Q8) being connected to the second voltage node, and a ninth transistor (Q9) of the first polarity having a base, an emitter and a collector, the emitter of the ninth transistor (Q9) being coupled to the first voltage node, the base and collector of the ninth transistor (Q9) being connected to the base common connection node of the first and second transistors (Q6, Q7), wherein the collectors of the first and second transistors (Q6, Q7) are used as current input and output terminals (12, 13) of the current mirror circuit (10) ;
**characterized by**
a correction circuit (30, 40, 50, 60, 70) including a fourth transistor (Q31) of the first polarity having a base, an emitter and a collector, the emitter of the fourth transistor (Q31) being coupled to the first voltage node, a fifth transistor (Q36) of the first polarity having a base, an emitter and a collector, the emitter of the fifth transistor (Q36) being coupled to the first voltage node, the base of the fifth transistor (Q36) being connected commonly to the base of the fourth transistor (Q31), the collector of the fifth transistor (Q36) being connected to the second voltage node, a sixth transistor (Q32) of the first polarity having a base, an emitter and a collector, the emitter of the sixth transistor (Q32) being coupled to the first voltage node, the base of the sixth transistor (Q32) being connected commonly to the bases of the fourth and fifth transistors (Q31, Q36), a seventh transistor (Q33) of the first polarity having a base, an emitter and collector, the emitter of the seventh transistor (Q33) being connected to a base common connection node of the fourth, fifth and sixth transistors (Q31, Q36, Q32), the base of the seventh transistor (Q33) being connected to the collector of the fourth transistor (Q31), the collector of the seventh transistor (Q331) being connected to the collector of the sixth transistor, and an eighth transistor (Q34) of the first polarity having a base, an emitter and a collector, the emitter of the eighth transistor (Q34) being connected to the collector of the seventh transistor (Q33), the base of the eighth transistor (Q34) being connected to the collector of the second transistor, the collector of the eighth transistor (Q34) being connected to the second voltage node.

2. Current source circuit according to claim 1, wherein the current source circuit further comprises:
a tenth transistor (Q37) of the second polarity having a base, an emitter and a collector, the collector of the tenth transistor (Q37) being connected to the first voltage node, the base of the tenth transistor (Q37) being connected to the emitter of the eighth transistor; and
a current source circuit (15) connected to the emitter of the ninth transistor.

3. Current source circuit according to claim 1, wherein
the current mirror circuit (10) further includes a first resistor (R1) connected between the emitter of the first transistor (Q6) and the first voltage node, and a second resistor (R2) connected between the emitter of the second transistor (Q7) and the first voltage node, and
said correction circuit (40; 50) further includes a third resistor (R11) connected between the emitter of the fourth transistor (Q31) and the first voltage node, a fourth resistor (R13) connected between the emitters of the fifth transistor (Q36) and the first voltage node, and a fifth resistor (R12) connected between the emitter of the sixth transistor (Q32) and the first voltage node.

4. Current source circuit according to claim 1, wherein
the current mirror circuit (10) further includes a first resistor (R1) connected between the emitter of the first transistor (Q6) and the first voltage node, a second resistor (R2) connected between the emitter of the second transistor (Q7) and the first voltage node, and a third resistor (R3) connected between the emitter of the ninth transistor (Q9) and the first voltage node, and
the correction circuit (40; 50) further includes a third resistor (R11) connected between the emitter of the fourth transistor (Q31) and the first voltage node, a fourth resistor (R13) connected between the emitter of the fifth transistor (Q36) and the first voltage node, and a fifth resistor (R12) connected between the emitter of the sixth transistor (Q32) and the first voltage node.

5. Current source circuit according to claim 1, wherein
in order to couple in the current mirror circuit (10) the emitter of the third transistor (Q8) to the base common connection node of the first and second transistors (Q6, Q7),
the current mirror circuit (10) further including a further transistor (Q10) of a second polarity opposite to said first polarity having a base, an emitter and a collector, the collector of the further transistor (Q10) being connected to the base common connection node of the first and second transistors (Q6, Q7), the emitter of the further transistor (Q10) being connected to the emitter of the third transistor (Q8); and
the correction circuit (30, 60, 70) further including a ninth transistor (Q35) of the second polarity having a base, an emitter and a collector, the base and the collector of the ninth transistor (Q35) being connected to the base of the further transistor (Q10), the emitter of the ninth transistor (Q35) being connected to the emitter of the eighth transistor (Q34).

6. Current source circuit according to claim 5, wherein the correction circuit (60) further includes a tenth transistor (Q36) of the first polarity having a base, an emitter and a collector, the emitter of the tenth transistor (Q36) being connected to the first voltage node, the base of the tenth transistor (Q36) being connected to the base common connection node of the fifth and sixth transistors (Q31, Q32), the collector of the tenth transistor (Q36) being connected to the second voltage node.

7. Current source circuit according to claim 5, wherein the correction circuit (70) further includes:
an eleventh transistor (Q37) of the second polarity having a base, an emitter and a collector, the collector of the eleventh transistor being connected to the first voltage node, the base of the eleventh transistor being connected to the emitter of the ninth transistor, and
a current source circuit (15) connected to the emitter of the eleventh transistor.

8. Current source circuit according to claim 5, wherein the current mirror circuit (10) further includes a twelfth transistor (Q9) of the first polarity having a base, an emitter and a connector, the emitter of the twelfth transistor being coupled to the first voltage node, the base of the twelfth transistor and the collector being connected to the base common connection node of the first and second transistors.

9. Current source circuit according to claim 5, wherein
the current mirror circuit (10) further includes a first resistor (R1) connected between the emitter of the first transistor and the first voltage node, a second resistor (R2) connected between the emitter of the second transistor and the first voltage node, and
the correction circuit (60; 70) further includes a third resistor (R11) connected between the emitter of the fifth transistor and the first voltage node, a fourth resistor (R12) connected between the emitter of the sixth transistor and the first voltage node, and a fifth resistor (R13) connected between the emitter of the tenth transistor (Q36) and the first voltage node.

10. Current source circuit according to claim 8, wherein the current mirror circuit (10) further includes a sixth resistor (R3) connected between the emitter of the twelfth transistor and the first voltage node.

## Patentansprüche

1. Stromquellenschaltung, umfassend:
einen ersten Spannungsknoten (11) an dem eine erste Spannung (VA) angelegt ist;
einen zweiten Spannungsknoten (14) an dem eine zweite Spannung, die kleiner ist als die erste Spannung, angelegt ist;
eine Stromspiegelschaltung (10) mit einem ersten Transistor (Q6) einer ersten Polarität mit einer Basis, einem Emitter und einem Kollektor, wobei der Emitter des ersten Transistors (Q6) mit dem ersten Spannungsknoten gekoppelt ist, einem zweiten Transistor (Q7) der ersten Polarität mit einer Basis, einem Emitter und einem Kollektor, wobei der Emitter des zweiten Transistors (Q7) mit dem ersten Spannungsknoten gekoppelt ist, und wobei die Basis des zweiten Transistors (Q7) gemeinsam mit der Basis des ersten Transistors (Q6) verbunden ist, und einen dritten Transistor (Q8) der ersten Polarität mit einer Basis, einem Emitter und einem Kollektor, wobei der Emitter des dritten Transistors (Q8) an einen Basisverbindungsknoten des ersten und zweiten Transistors (Q6, Q7) gekoppelt ist, und wobei die Basis des dritten Transistors (Q8) mit dem Kollektor des ersten Transistors (Q6) verbunden ist, und wobei der Kollektor des dritten Transistors (Q8) mit dem zweiten Spannungsknoten verbunden ist, und einen neunten Transistor (Q9) der ersten Polarität mit einer Basis, einem Emitter und einem Kollektor, wobei der Emitter des neunten Transistors (Q9) mit dem ersten Spannungsknoten gekoppelt ist, und wobei die Basis und der Kollektor des neunten Transistors (Q9) mit dem Basisverbindungsknoten des ersten und zweiten Transistors (Q6, Q7) verbunden ist, und wobei die Kollektoren des ersten und zweiten Transistors (Q6, Q7) als Stromeingangs- und ausgangsklemmen (12, 13) der Stromspiegelschaltung (10) benutzt werden;
**gekennzeichnet durch**
eine Korrekturschaltung (30, 40, 50, 60, 70) mit einem vierten Transistor (Q31) der ersten Polarität mit einer Basis, einem Emitter und einem Kollektor, wobei der Emitter des vierten Transistors (Q31) an den ersten Spannungsknoten gekoppelt ist, einen fünften Transistor (Q36) der ersten Polarität mit einer Basis, einem Emitter und einem Kollektor, wobei der Emitter des fünften Transistors (Q36) an den ersten Spannungsknoten gekoppelt ist, und wobei die Basis des fünften Transistors (Q36) gemeinsam mit der Basis des vierten Transistors (Q31) verbunden ist, und wobei der Kollektor des fünften Transistors (Q36) mit dem zweiten Spannungsknoten verbunden ist, einen sechsten Transistor (Q32) der ersten Polarität mit einer Basis, einem Emitter und einem Kollektor, wobei der Emitter des sechsten Transistors (Q32) an den ersten Spannungsknoten gekoppelt ist, und wobei die Basis des sechsten Transistors (Q32) gemeinsam mit den Basen des vierten und fünften Transistors (Q31, Q36) verbunden ist, einen siebten Transistor (Q33) der ersten Polarität mit einer Basis, einem Emitter und einem Kollektor, wobei der Emitter des siebten Transistors (Q33) mit einem Basisverbindungsknoten des vierten, fünften und sechsten Transistors (Q31, Q36, Q32) verbunden ist, und wobei die Basis des siebten Transistors (Q33) mit dem Kollektor des vierten Transistors (Q31) verbunden ist, und wobei der Kollektor des siebten Transistors (Q33) mit dem Kollektor des sechsten Transistors verbunden ist und einen achten Transistor (Q34) der ersten Polarität mit einer Basis, einem Emitter und einem Kollektor, wobei der Emitter des achten Transistors (Q34) mit dem Kollektor des siebten Transistors (Q33) verbunden ist, und wobei die Basis des achten Transistors (Q34) mit dem Kollektor des zweiten Transistors verbunden ist, und wobei der Kollektor des achten Transistors (Q34) mit dem zweiten Spannungsknoten verbunden ist.

2. Stromquellenschaltung nach Anspruch 1, wobei die Stromquellenschaltung ferner umfasst:
einen zehnten Transistor (Q37) der zweiten Polarität mit einer Basis, einem Emitter und einem Kollektor, wobei der Kollektor des zehnten Transistors (Q37) mit dem ersten Spannungsknoten verbunden ist, und wobei die Basis des zehnten Transistors (Q37) mit dem Emitter des achten Transistors verbunden ist; und
eine mit dem Emitter des neunten Transistors verbundene Stromquellenschaltung (15).

3. Stromquellenschaltung nach Anspruch 1, wobei
die Stromspiegelschaltung (10) ferner einen ersten zwischen dem Emitter des ersten Transistors (Q6) und dem ersten Spannungsknoten verbundenen Widerstand (R1) und einen zweiten zwischen dem Emitter des zweiten Transistors (Q6) und dem ersten Spannungsknoten verbundenen Widerstand (R2) beinhaltet, und
die Korrekturschaltung (40; 50) ferner einen dritten zwischen dem Emitter des vierten Transistors (Q31) und dem ersten Spannungsknoten verbundenen Widerstand (R11), einen vierten zwischen dem Emitter des fünften Transistors (Q36) und dem ersten Spannungsknoten verbundenen Widerstand (R13) und einen fünften zwischen dem Emitter des sechsten Transistors (Q32) und dem ersten Spannungsknoten verbundenen Widerstand (R12) beinhaltet.

4. Stromquellenschaltung nach Anspruch 1, wobei
die Stromspiegelschaltung (10) ferner einen ersten zwischen dem Emitter des ersten Transistors (Q6) und dem ersten Spannungsknoten verbundenen Widerstand (R1), einen zweiten zwischen dem Emitter des zweiten Transistors (Q7) und dem ersten Spannungsknoten verbundenen Widerstand (R2) und einen dritten zwischen dem Emitter des neunten Transistors (Q9) und dem ersten Spannungsknoten verbundenen Widerstand (R3) beinhaltet, und
die Korrekturschaltung (40; 50) ferner einen dritten zwischen dem Emitter des vierten Transistors (Q31) und dem ersten Spannungsknoten verbundenen Widerstand (R11), einen vierten zwischen dem Emitter des fünften Transistors (Q36) und dem ersten Spannungsknoten verbundenen Widerstand (R13) und einen fünften zwischen dem Emitter des sechsten Transistors (Q32) und dem ersten Spannungsknoten verbundenen Widerstand (R12) beinhaltet.

5. Stromquellenschaltung nach Anspruch 1, wobei
um in der Stromspiegelschaltung (10) den Emitter des dritten Transistors (Q8) an den Basisverbindungsknoten des ersten und zweiten Transistors (Q6, Q7) zu koppeln,
die Stromspiegelschaltung (10) ferner einen weiteren Transistor (Q10) der zweiten Polarität gegensätzlich zu der ersten Polarität umfasst, mit einer Basis, einem Emitter und einem Kollektor, wobei der Kollektor des weiteren Transistors (Q10) mit dem Basisverbindungsknoten des ersten und zweiten Transistors (Q6, Q7) verbunden ist, und wobei der Emitter des weiteren Transistors (Q10) mit dem Emitter des dritten Transistors (Q8) verbunden ist; und
die Korrekturschaltung (30, 60, 70) ferner einen neunten Transistor (Q35) der zweiten Polarität umfasst, mit einer Basis, einem Emitter und einem Kollektor, wobei die Basis und der Kollektor des neunten Transistors (Q35) mit der Basis des weiteren Transistors (Q10) verbunden ist, und wobei der Emitter des neunten Transistors (Q35) mit dem Emitter des achten Transistors (Q34) verbunden ist.

6. Stromquellenschaltung nach Anspruch 5, wobei die Korrekturschaltung (60) ferner einen zehnten Transistor (Q36) der ersten Polarität beinhaltet, mit einer Basis, einem Emitter und einem Kollektor, wobei der Emitter des zehnten Transistors (Q36) mit dem ersten Spannungsknoten verbunden ist, und wobei die Basis des zehnten Transistors (Q36) mit dem Basisverbindungsknoten des fünften und sechsten Transistors (Q31, Q32) verbunden ist, und wobei der Kollektor des zehnten Transistors (Q36) mit dem zweiten Spannungsknoten verbunden ist.

7. Stromquellenschaltung nach Anspruch 5, wobei die Korrekturschaltung (70) ferner beinhaltet:
einen elften Transistor (Q37) der zweiten Polarität mit einer Basis, einem Emitter und einem Kollektor, wobei der Kollektor des elften Transistors mit dem ersten Spannungsknoten verbunden ist, und wobei die Basis des elften Transistors mit dem Emitter des neunten Transistors verbunden ist, und
eine mit dem Emitter des elften Transistors verbundene Stromquellenschaltung (15).

8. Stromquellenschaltung nach Anspruch 5, wobei die Stromspiegelschaltung (10) ferner einen zwölften Transistor (Q9) der ersten Polarität beinhaltet, mit einer Basis, einem Emitter und einem Kollektor, wobei der Emitter des zwölften Transistors mit dem ersten Spannungsknoten verbunden ist, und wobei die Basis des zwölften Transistors und der Kollektor mit dem Basisverbindungsknoten des ersten und zweiten Transistors verbunden ist.

9. Stromquellenschaltung nach Anspruch 5, wobei
die Stromspiegelschaltung (10) ferner einen ersten zwischen dem Emitter des ersten Transistors und dem ersten Spannungsknoten verbundenen Widerstand (R1) und einen zweiten zwischen dem Emitter des zweiten Transistors und dem ersten Spannungsknoten verbundenen Widerstand (R2) beinhaltet, und
die Korrekturschaltung (60; 70) ferner einen dritten zwischen dem Emitter des fünften Transistors und dem ersten Spannungsknoten verbundenen Widerstand (R11), einen vierten zwischen dem Emitter des sechsten Transistors und dem ersten Spannungsknoten verbundenen Widerstand (R12) und einen fünften zwischen dem Emitter des zehnten Transistors (Q36) und dem ersten Spannungsknoten verbundenen Widerstand (R13) beinhaltet.

10. Stromquellenschaltung nach Anspruch 8, wobei die Stromspiegelschaltung (10) ferner einen sechsten zwischen dem Emitter des-zwölften Transistors und dem ersten Spannungsknoten verbundenen Widerstand (R3) beinhaltet.

## Revendications

1. Circuit de source de courant comprenant :
un premier noeud de tension (11) sur lequel une première tension (VA) est appliquée ;
un second noeud de tension (14) sur lequel une seconde tension qui est inférieure à la première tension est appliquée ;
un circuit miroir de courant (10) qui inclut un premier transistor (Q6) d'une première polarité comportant une base, un émetteur et un collecteur, l'émetteur du premier transistor (Q6) étant couplé au premier noeud de tension, un second transistor (Q7) de la première polarité comportant une base, un émetteur et un collecteur, l'émetteur du second transistor (Q7) étant couplé au premier noeud de tension, la base du second transistor (Q7) étant connectée de façon commune à la base du premier transistor (Q6) et un troisième transistor (Q8) de la première polarité comportant une base, un émetteur et un collecteur, l'émetteur du troisième transistor (Q8) étant couplé à un noeud de connexion commun de bases des premier et second transistors (Q6, Q7), la base du troisième transistor (Q8) étant connectée au collecteur du premier transistor (Q6), le collecteur du troisième transistor (Q8) étant connecté au second noeud de tension et un neuvième transistor (Q9) de la première polarité comportant une base, un émetteur et un collecteur, l'émetteur du neuvième transistor (Q9) étant couplé au premier noeud de tension, la base et le collecteur du neuvième transistor (Q9) étant connectés au noeud de connexion commun de bases des premier et second transistors (Q6, Q7), dans lequel les collecteurs des premier et second transistors (Q6, Q7) sont utilisés en tant que bornes d'entrée et de sortie de courant (12, 13) du circuit miroir de courant (10),
**caractérisé par** :
un circuit de correction (30, 40, 50, 60, 70) incluant un quatrième transistor (Q31) de la première polarité comportant une base, un émetteur et un collecteur, l'émetteur du quatrième transistor (Q31) étant couplé au premier noeud de tension, un cinquième transistor (Q36) de la première polarité comportant une base, un émetteur et un collecteur, l'émetteur du cinquième transistor (Q36) étant couplé au premier noeud de tension, la base du cinquième transistor (Q36) étant connectée de façon commune à la base du quatrième transistor (Q31), le collecteur du cinquième transistor (Q36) étant connecté au second noeud de tension, un sixième transistor (Q32) de la première polarité comportant une base, un émetteur et un collecteur, l'émetteur du sixième transistor (Q32) étant couplé au premier noeud de tension, la base du sixième transistor (Q32) étant connectée de façon commune aux bases des quatrième et cinquième transistors (Q31, Q36), un septième transistor (Q33) de la première polarité comportant une base, un émetteur et un collecteur, l'émetteur du septième transistor (Q33) étant connecté à un noeud de connexion commun de bases des quatrième, cinquième et sixième transistors (Q31, Q36, Q32), la base du septième transistor (Q33) étant connectée au collecteur du quatrième transistor (Q31), le collecteur du septième transistor (Q33) étant connecté au collecteur du sixième transistor et un huitième transistor (Q34) de la première polarité comportant une base, un émetteur et un collecteur, l'émetteur du huitième transistor (Q34) étant connecté au collecteur du septième transistor (Q33), la base du huitième transistor (Q34) étant connectée au collecteur du second transistor, le collecteur du huitième transistor (Q34) étant connecté au second noeud de tension.

2. Circuit de source de courant selon la revendication 1, dans lequel le circuit de source de courant comprend en outre :
un dixième transistor (Q37) de la seconde polarité comportant une base, un émetteur et un collecteur, le collecteur du dixième transistor (Q37) étant connecté au premier noeud de tension, la base du dixième transistor (Q37) étant connecté à l'émetteur du huitième transistor ; et
un circuit de source de courant (15) qui est connecté à l'émetteur du neuvième transistor.

3. Circuit de source de courant selon la revendication 1, dans lequel:
le circuit miroir de courant (10) inclut en outre une première résistance (R1) qui est connectée entre l'émetteur du premier transistor (Q6) et le premier noeud de tension et une seconde résistance (R2) qui est connectée entre l'émetteur du second transistor (Q7) et le premier noeud de tension ; et
ledit circuit de correction (40 ; 50) inclut en outre une troisième résistance (R11) qui est connectée entre l'émetteur du quatrième transistor (Q31) et le premier noeud de tension, une quatrième résistance (R13) qui est connectée entre l'émetteur du cinquième transistor (Q36) et le premier noeud de tension et une cinquième résistance (R12) qui est connectée entre l'émetteur du sixième transistor (Q32) et le premier noeud de tension.

4. Circuit de source de courant selon la revendication 1, dans lequel :
le circuit miroir de courant (10) inclut en outre une première résistance (R1) qui est connectée entre l'émetteur du premier transistor (Q6) et le premier noeud de tension, une seconde résistance (R2) qui est connectée entre l'émetteur du second transistor (Q7) et le premier noeud de tension et une troisième résistance (R3) qui est connectée entre l'émetteur du neuvième transistor (Q9) et le premier noeud de tension ; et
le circuit de correction (40 ; 50) inclut en outre une troisième résistance (R11) qui est connectée entre l'émetteur du quatrième transistor (Q31) et le premier noeud de tension, une quatrième résistance (R13) qui est connectée entre l'émetteur du cinquième transistor (Q36) et le premier noeud de tension et une cinquième résistance (R12) qui est connectée entre l'émetteur du sixième transistor (Q32) et le premier noeud de tension.

5. Circuit de source de courant selon la revendication 1, dans lequel :
afin de coupler dans le circuit miroir de courant (10) l'émetteur du troisième transistor (Q8) au noeud de connexion commun de bases des premier et second transistors (Q6, Q7),
le circuit miroir de courant (10) inclut en outre un autre transistor (Q10) d'une seconde polarité opposée à ladite première polarité comportant une base, un émetteur et un collecteur, le collecteur de l'autre transistor (Q10) étant connecté au noeud de connexion commun de bases des premier et second transistors (Q6, Q7), l'émetteur de l'autre transistor (Q10) étant connecté à l'émetteur du troisième transistor (Q8) ; et
le circuit de correction (30, 60, 70) inclut en outre un neuvième transistor (Q35) de la seconde polarité comportant une base, un émetteur et un collecteur, la base et le collecteur du neuvième transistor (Q35) étant connectés à la base de l'autre transistor (Q10), l'émetteur du neuvième transistor (Q35) étant connecté à l'émetteur du huitième transistor (Q34).

6. Circuit de source de courant selon la revendication 5, dans lequel le circuit de correction (60) inclut en outre un dixième transistor (Q36) de la première polarité comportant une base, un émetteur et un collecteur, l'émetteur du dixième transistor (Q36) étant connecté au premier noeud de tension, la base du dixième transistor (Q36) étant connectée au noeud de connexion commun de bases des cinquième et sixième transistors (Q31, Q32), le collecteur du dixième transistor (Q36) étant connecté au second noeud de tension.

7. Circuit de source de courant selon la revendication 5, dans lequel le circuit de correction (70) inclut en outre :
un onzième transistor (Q37) de la seconde polarité comportant une base, un émetteur et un collecteur, le collecteur du onzième transistor étant connecté au premier noeud de tension, la base du onzième transistor étant connectée à l'émetteur du neuvième transistor ; et
un circuit de source de courant (15) qui est connecté à l'émetteur du onzième transistor.

8. Circuit de source de courant selon la revendication 5, dans lequel le circuit miroir de courant (10) inclut en outre un douzième transistor (Q9) de la première polarité comportant une base, un émetteur et un collecteur, l'émetteur du douzième transistor étant couplé au premier noeud de tension, la base du douzième transistor et le collecteur étant connectés au noeud de connexion commun de bases des premier et second transistors.

9. Circuit de source de courant selon la revendication 5, dans lequel :
le circuit miroir de courant (10) inclut en outre une première résistance (R1) qui est connectée entre l'émetteur du premier transistor et le premier noeud de tension, une seconde résistance (R2) qui est connectée entre l'émetteur du second transistor et le premier noeud de tension ; et
le circuit de correction (60 ; 70) inclut en outre une troisième résistance (R11) qui est connectée entre l'émetteur du cinquième transistor et le premier noeud de tension, une quatrième résistance (R12) qui est connectée entre l'émetteur du sixième transistor et le premier noeud de tension et une cinquième résistance (R13) qui est connectée entre l'émetteur du dixième transistor (Q36) et le premier noeud de tension.

10. Circuit de source de courant selon la revendication 8, dans lequel le circuit miroir de courant (10) inclut en outre une sixième résistance (R3) qui est connectée entre l'émetteur du douzième transistor et le premier noeud de tension.
